# EUROPEAN PATENT APPLICATION

(11) **EP 1 857 292 A1**
(43) Date of publication of application: **21.11.2007**
(21) Application number: 06712040.2
(22) Date of filing: 20.01.2006
(51) Int. Cl.: B41N 1/14, G03F 7/00, G03F 7/004, G03F 7/09, G03F 7/11

(54) **LITHOGRAPHIC PRINTING PLATE MATERIAL, METHOD OF PRINTING THEREWITH AND METHOD OF RECOVERING PLASTIC SUPPORT**

(30) Priority: 27.01.2005 JP 2005019670
(71) Applicant: Konica Minolta Medical & Graphic, Inc., Tokyo 163-0512 (JP)
(72) Inventor: EZURE, Hidetoshi, kawa-machi, Hachioji-shi, Tokyo, 1928505 (JP)
(74) Representative: Rees, Alexander Ellison
(86) International application number: PCT/JP2006/300815
(87) International publication number: WO 2006/080244

(57) **Abstract**

Disclosed are a printing plate material and a printing method that excel in on-press developability and printing durability and further in environmental aptitude, and an excellent method of collecting a plastic support. There is provided a planographic printing plate material comprising a plastic support and provided thereon, at least an image formation layer, wherein the plastic support is comprised of a resin whose main component is polylactic acid.

## Description

### FIELD OF THE INVENTION

The present invention relates to a planographic printing plate material, a printing method employing the same, and a method of collecting a plastic support.

### TECHNICAL BACKGROUND

In recent years, a computer to plate (CTP) system, in which image data can be directly recorded in a printing plate material, has been widely used in conjunction with the digitization of printing data. As a usable printing plate material for CTP, there are a printing plate material comprising an aluminum support such as a conventional PS plate, and a flexible printing plate material comprising a flexible resin film sheet and provided thereon, various functional layers. As for CTP system, on-press development is well known in which a printing plate material after writing image data (imagewise exposure) is mounted directly on an off-set press, and supplied with dampening water thereto on printing, whereby only the image formation layer at non-image portions is swollen or dissolved by the dampening water and transferred to a printing paper (paper waste) at an initial stage of printing to remove (refer to Patent Documents 1 and 2).

This printing plate material capable of subjected to on-press development can provide sharp dot images and high quality images and does not require any specific development after exposure, and has been used in view of recent strong demand of environmental protection.

Planographic printing plate materials employing a plastic support are collected after use, and a part of them is subjected to recycling treatment, but most of them are burnt or buried into ground.

A planographic printing plate material, which is required to have multi-functionality, comprises layers with various functions composed of materials with different characteristics. In the conventional technique, several kinds of treatments are necessary in order to separate the layers from a plastic support of the planographic printing plate material after use, resulting in cost increase in collecting the plastic support.

In the burning treatment, too strong force of the fire does damage to the furnace damage and a large amount of fuel is required, resulting in cost increase, while in the burying treatment, there is problem in that the wastes, which do not have a biodegradation property, remain semi-permanently in ground without being decomposed. Accordingly, a planographic printing plate material is required which has high biodegradation property and enables separation and collection of the plastic film therefrom with reduced treatments.
Patent document 1
   Japanese Patent O.P.I. Publication No. 9-123387
Patent document 2
   Japanese Patent O.P.I. Publication No. 9-123388

### DISCLOSURE OF THE INVENTION

### PROBLEMS TO BE SOLVED BY THE INVENTION

An object of the invention is to provide a printing plate material and method of printing which are excellent in on-press developability, printing durability and environmental aptitude, and to provide an excellent method of collecting a plastic support.

### MEANS FOR SOLVING THE ABOVE PROBLEMS

The above object has been attained by one of the following constitutions:
1. A planographic printing plate material comprising a plastic support and provided thereon, at least an image formation layer, wherein the plastic support is comprised of a polymer whose main component is polylactic acid.
2. The planographic printing plate material of item 1, wherein a layer capable of being separated from the plastic support with an alkali solution having a pH of from 9 to 12 is provided on the plastic support.
3. The planographic printing plate material of item 1 or 2, wherein the image formation layer is capable of being subjected to on-press development.
4. The planographic printing plate material of any one of items 1 through 3, wherein a subbing layer containing at least one compound selected from the group consisting of a vinyl polymer, polyester and an acryl-modified polyester is provided on the plastic support.
5. The planographic printing plate material of any one of items 1 through 4, wherein the planographic printing plate material is in the form of roll.
6. A printing method comprising the steps of forming an image on the planographic printing plate material of any one of items 1 through 5, employing a thermal head or a thermal laser; developing the resulting planographic printing plate material on a planographic printing press by supplying dampening water or both of dampening water; and printing ink thereto, and carrying out printing.
7. A method of collecting the plastic support from the planographic printing plate material of any one of items 1 through 5, the method comprising processing the planographic printing plate material with an alkali solution having a pH of from 9 to 12.
8. A planographic printing plate material comprising a plastic support and provided thereon, at least an image formation layer, wherein a layer capable of being separated from the plastic support with an alkali solution having a pH of from 9 to 12 is provided on the plastic support.
9. The planographic printing plate material of item 8, wherein the image formation layer is capable of being subjected to on-press development.
10. The planographic printing plate material of item 8 or 9, wherein a subbing layer containing at least one compound selected from the group consisting of a vinyl polymer, polyester and an acryl-modified polyester is provided on the plastic support.
11. The planographic printing plate material of any one of items 8 through 10, wherein the planographic printing plate material is in the form of roll.
12. A printing method comprising the steps of forming an image on the planographic printing plate material of any one of items 8 through 11, employing a thermal head or a thermal laser; developing the resulting planographic printing plate material on a planographic printing press by supplying dampening water or both of dampening water and printing ink thereto; and carrying out printing.
13. A method of collecting the plastic support from the planographic printing plate material of any one of items 8 through 11, the method comprising processing the planographic printing plate material with an alkali solution having a pH of from 9 to 12.

The present inventor has made an extensive study on the above problems, and has employed (1) a biodegradable polylactic acid as a polymer constituting a plastic support, (2) materials dissolving in an alkali solution having a pH of from 9 to 12 in a layer constituting a printing plate material, (3) a compound (acryl resin, polyester or an acryl-modified polyester) dissolving in an alkali solution having a pH of from 9 to 12 in a subbing layer, and (4) an image formation layer capable of being subjected to on-press development.

The present inventor has found that a printing plate material that excels in on-press developability, printing durability and environmental aptitude can be obtained by employing any one of (1) through (4) above or a combination of thereof, and has completed the invention.

### EFFECTS OF THE INVENTION

The printing plate material, printing method and plastic support collecting method according to the invention provide effects that excel in on-press developability, printing durability and environmental aptitude.

### PREFERRED EMBODIMENTS OF THE INVENTION

In item 1 above, the biodegradable polylactic acid as a main constituent of a polymer constituting a plastic support provides film capable of being subjected to composting treatment, and improves environmental aptitude. The printing plate material after employed is processed with an alkali solution having a pH of from 9 to 12, whereby the plastic support and the component layers can be easily separated and the plastic film can be recycled.

The alkali solution as above has a pH of preferably from 9 to 12, in view of the separation, collection or environmental protection.

Constituents for the plastic support according to items 9 through 15 above in the present invention are plastic films. Examples of the plastic include polyethylene terephthalate (PET), polyethylene naphthalate (PEN), polyimide, polyamide, polycarbonate, polysulfone, polyphenylene oxide, cellulose ester, and a polymer whose main component is polylactic acid. Of these, a polymer whose main component is polylactic acid is preferred.

A polymer constituting the plastic support in the invention is one whose main component is polylactic acid. Examples thereof include a lactic acid homopolymer, a copolymer of lactic acid and another hydroxy and carboxylic acid monomer and an admixture thereof. As the lactic acid constituting the polymer, there are L-lactic acid, D-lactic acid, and an admixture thereof. Examples of another hydroxy and carboxylic acid monomer used in addition to lactic acid include glycolic acid, 3-hydroxybutyric acid, 4-hydroxybutyric acid, 3-hydroxyvaleric acid, 4-hydroxyvaleric acid, and 6-hydroxycaproic acid. Further, dicarboxylic acids or glycols can be employed unless the effects of the invention are jeopardized. The component other than the lactic acid in the polymer is preferably contained in the polymer so that the lactic acid content of the polymer is not less than 50 mol%.

In items 9 through 15 above in the invention, PET also is preferably employed as the support, in view of handling property of the printing plate material and recycling property of the plastic in the printing plate material.

PET is composed of terephthalic acid and ethylene glycol, and PEN is also composed of naphthalene dicarboxylic acid and ethylene glycol. These are combined via polycondensation under the appropriate reaction condition employing a catalyst. In this case, one or more kinds of a third component may be appropriately mixed. The third component may be a compound capable having a divalent ester-forming group. Examples of a dicarboxylic acid will be shown below.

As the dicarboxylic acid, there are, for example, isophthalic acid, phthalic acid, 2,6-naphthalene dicarboxylic acid, a polymer having polylactic acid as a main component, 2,7-naphthalene dicarboxylic acid, diphenylsulfone dicarboxylic acid, diphenylether dicarboxylic acid, diphenylethane dicarboxylic acid, cyclohexane dicarboxylic acid, diphenyl dicarboxylic acid, diphenylthioether dicarboxylic acid, diphenylketone dicarboxylic acid, and diphenylindane dicarboxylic acid. As a glycol, there are, for example, ethylene grycol, propylene glycol, tetramethylene glycol, cyclohexanedimethanol, 2,2-bis(4-hydroxyphenyl)propane, 2,2-bis(4-hydroxyethoxyphenyl)propane, bis(4-hydroxyphenyl)-sulfone, bisphenolfluorene dihydroxyethyl ether, diethylene glycol, neopentylene glycol, hydroquinone, and cyclohexane diol. The intrinsic viscosity of PET resin or film used in the present invention is preferably 0.5 to 0.8. Those having different viscosity may be used in combination.

A synthesis method of PET is not specifically limited, and PET can be manufactured according to a conventional manufacturing method. As the manufacturing method, there is a direct esterification method in which a dicarboxylic acid component is directly reacted with a diol component, or an ester exchange method in which dialkylester is first employed as dicarboxylic acid, and this one and the diol component are polymerized via the ester exchange reaction by heat application to be esterified while removing the extra diol under reduced pressure. In this case, an ester exchange catalyst, a polymerization catalyst or a heat-resistant stabilizer can be added. Examples of the heat stabilizer include phosphoric acid, phosphorous acid, and ester compounds thereof. During synthesis, an anti-stain agent, a crystal nucleus agent, a slipping agent, a stabilizer, an anti-blocking agent, a UV absorber, a viscosity adjusting agent, a transparentizing agent, an anti-static agent, a pH adjusting agent, a dye or pigment may be added.

Next, a manufacturing method of the plastic support will be explained.

A method of preparing an unstretched sheet and a sheet which is uniaxially stretched in the longitudinal direction can be a commonly known method. Polyester as a raw material is molded in the form of pellets, and after a hot-air drying process or a vacuum drying, they are melted and extruded in the form of sheets by a T-shaped die. Subsequently, they are attached firmly onto a cooling drum and cooled rapidly to obtain an unstretched sheet. Next, the resulting unstretched sheet is heated in the range of from the glass transition temperature (Tg) to Tg + 100 °C via plural rollers and/or heating apparatuses such as an infrared heater and the like to be stretched in the longitudinal direction. The stretching magnification is usually 2.5 to 6.

In this case, a roll-set curl can be avoided by arranging a stretching temperature difference between both surfaces of a support. Specifically, temperature can be controlled by providing a heating apparatus such as an infrared heater or such on one surface side during heating while stretching in the longitudinal direction. The temperature difference at the time of stretching is preferably 0 to 40 °C, and more preferably 0 to 20 °C. In the case of the temperature difference exceeding 40 °C, it is not preferable that film sheet flatness is degraded because of uneven stretching.

Next, the resulting polyester film sheet which is uniaxially stretched in the longitudinal direction is stretched in the transverse direction in the temperature range of from Tg to Tg + 120 °C, and subsequently fixed by heat. The transverse stretching magnification is usually 3 to 6, and the ratio of longitudinal and transverse stretching magnifications is appropriately adjusted so as to have a preferable property via measuring of properties of the resulting biaxially stretching film sheet. As to heat fixation, a heat fixation process is usually conducted in the temperature range of not more than Tg + 180 °C, which is higher than the final transverse stretching temperature, for 0.5 to 300 sec. In this case, film sheets are preferably heat fixed with two or more temperatures. Dimension stability of the film sheets heat fixed with such the two or more temperatures is improved, whereby a support can usefully be provided for the printing plate material.

The support for the printing plate material in the present invention is preferably subjected to relaxation treatment in view of dimension stability. The relaxation treatment can preferably be conducted before a roll-up process in a tenter for stretching in the transverse direction or in the exterior of the tenter after heat fixing in the stretching process of the foregoing polyester film sheet. The relaxation treatment is preferably carried out in a temperature of 80 to 200 °C, and more preferably 100 to 180 °C. The relaxation treatment is also carried out preferably in a rate of 0.1 to 10% in both longitudinal and transverse directions, and more preferably in a rate of 2 to 6%.

Particles having a size of 0.01 to 10 µm are preferably incorporated in an amount of 1 to 1000 ppm into the above support, in improving handling property.

Herein, the particles may be organic or inorganic material.

The plastic support in the present invention has a coefficient of elasticity of preferably 300 to 800 kg/mm², and more preferably 400 to 600 kg/mm², in view of the above handling property. The coefficient of elasticity herein referred to is a slope of the straight line portion in the stress-strain diagram showing the relationship between strain and stress, which is obtained employing a tension test meter according to JIS C2318. This slope is called Young's modulus, which is defined in the invention as coefficient of elasticity.

It is preferred that the plastic support in the invention has an average thickness of from 100 to 500 µm, and a thickness distribution of not more than 5%, in that a handling property is improved when the planographic printing plate material is mounted on a press. The average thickness of the support in the invention is preferably from 120 to 300 µm, and the thickness dispersion of the support in the invention is preferably not more than 2%.

The plastic support of the present invention may be subjected to heat treatment to reduce the roll-set curl. Provided as the heat treating method are a method in which heat treatment is carried out before and after rolling up in the form of roll after coating and drying each component layer of the printing plate material, and a method in which heat treatment is carried out by using a transport line while coating and drying each component layer of the printing plate material.

As a method of heat treatment in the form of roll, there is a method in which heat treatment is carried out at a temperature below the glass transition temperature for 0.1 to 1500 hours after preparing a polyester support, as described in Japanese Patent O.P.I. Publication No. 51-16358. As for a method of heat treatment by using a transport line, the roll-set curl can be minimized by heat treating while transporting a zone having a temperature slope between a glass transition temperature and not less than the glass transition temperature, as described in Japanese Patent O.P.I. Publication No. 10-39448.

In the invention, the subbing layer provided on both surfaces of the plastic support contains acryl resin, polyester, or acryl-modified polyester, which dissolves in an alkali solution with a pH of from 9 to 12, improves recycling property of the support, and provides excellent adhesion to the plastic support, excellent on-press development and printing durability.

### (Polyester)

A substantively linear polyester obtained via a polycondensation reaction of either polybasic acid or its ester, and either polyol or its ester, is used as polyester. Further in the case of being used in the water-soluble form, employed is polyester into which an example of a component having a hydrophilic group including a sulfonate-containing component, a diethylene glycol component, a polyalkylene ether glycol component, or a polyether dicarboxylic acid component is introduced as a copolymerization component. Sulfonate-containing dicarboxylic acid (dicarboxylic acid is hereinafter also referred to as polybasic acid) is preferably employed as a component having a hydrophilic group.

Examples employed as a polyester polybasic acid component include terephthalic acid, isophthalic acid, phthalic acid, phthalic anhydride, 2, 6-naphthalene dicarboxylic acid, 1, 4-cyclohexane dicarboxylic acid, adipic acid, sebacic acid, trimellitic acid, pyromellitic acid, dimer acid, maleic acid, fumaric acid, itaconic acid, p-hydroxybenzoic acid, and p-(β-hydroxy ethoxy) benzoic acid. A component having sulfonic-acid alkaline metal salt is preferably used as the above sulfonate-containing dicarboxylic acid. Alkaline metal salt of 4-sulfoisophthalic acid, 5-sulfoisophthalic acid, sulfoterephthalic acid, 4-sulfophthalic acid, 4-sulfonaphthalene-2, 7-dicarboxylic acid, and 5-(4-sulfophenoxy) isophthalic acid are provided as examples. Of these, 5-sulfoisophthalic acid sodium salt is especially preferred.

It is preferred from the aspect of water solubility and water resistance that the content of the dicarboxylic acid having a sulfonate is 5 to 15 mol%, based on the total dicarboxylic acid component, but is more preferably 6 to 10 mol%. A major dicarboxylic acid component having terephthalic acid and isophthalic acid is preferably used as water-soluble polyester, and it is further especially preferred, from the aspect of coatability and water solubility of a polyester support, that the content ratio of terephthalic acid and isophthalic acid is 30/70 to 70/30 in mol%. The content of these terephthalic acid and isophthalic acid components is preferably 50 to 80 mol%, based on the total dicarboxylic acid component, and it is further preferred that an alicyclic dicarboxylic acid is employed as a copolymerization component.

Examples provided as the alicyclic dicarboxylic acid include 1, 4-cyclohexane dicarboxylic acid, 1, 3-cyclohexane dicarboxylic acid, 1, 2-cyclohexane dicarboxylic acid, 1, 3-cyclopentane dicarboxylic acid, and 4, 4'-bicyclohexyl dicarboxylic acid.

Dicarboxylic acid other than the above dicarboxylic acids can also be used as a copolymerization component in the water-soluble polyester containing terephthalic acid and isophthalic acid as the main dicarboxylic acid component.

Examples thereof include aromatic dicarboxylic acid and straight-chained aliphatic dicarboxylic acid. The aromatic dicarboxylic acid is preferably used in the range of not more than 30 mol%, based on the total dicarboxylic acid component. Examples provided as the aromatic dicarboxylic acid include phthalic acid, 2, 5-dimethyl terephthalic acid, 2, 6-naphthalene dicarboxylic acid, 1, 4-naphthalene dicarboxylic acid, and biphenyl dicarboxylic acid. Straight-chained aliphatic dicarboxylic acid is preferably used in the range of not more than 15 mol%, based on the total dicarboxylic acid component. Examples provided as the straight-chained aliphatic dicarboxylic acid include adipic acid, pimelic acid, suberic acid, azelaic acid, and sebacic acid.

Examples employed also as a polyol component include ethylene glycol, diethylene glycol, 1,4-butanediol, neopentylglycol, dipropylene glycol, 1,6-hexanediol, 1, 4-cyclohexanedimethanol, xylylene glycol, trimethylolpropane, poly (ethylene oxide) glycol, and poly (tetramethylene oxide) glycol. Ethylene glycol, in the range not less than 50 mol%, is preferably used as a glycol component of the water-soluble polyester, based on the total glycol component.

Polyester can be synthesized, employing either dicarboxylic acid or its ester, and either glycol or its ester, as the starting raw material, for which various methods can be employed to synthesize it. An initial condensed material of dicarboxylic acid and glycol, for example, is formed by an ester exchange method or a direct esterification method, and further the polyester resin can be acquired by a commonly known manufacturing method via melt-polymerization of the initial condensation material.

As more specific examples, provided are methods such as a method of conducting a polycondensation process under high vacuum by decreasing pressure gradually after ester exchange reaction is conducted with ester of dicarboxylic acid which is, for example, dimethylester of dicarboxylic acid, and glycol, whereby methanol is distilled, a method of conducting a polycondensation process under high vacuum by gradually decreasing pressure after esterification reaction is conducted with dicarboxylic acid and glycol, whereby produced water is distilled, and also a method of conducting a polycondensation process under high vacuum after conducting esterification reaction by adding dicarboxylic acid. A commonly known catalyst can be employed as an ester exchange catalyst or a polycondensation catalyst. Examples used as the ester exchange catalyst include manganese acetate, calcium acetate, and zinc acetate. Examples used as the polycondensation catalyst include antimony trioxide, germanium oxide, dibutyltin oxide, and titanium tetrabutoxide. Various conditions of processes and components including polymerization and catalyst, however, are not limited to the above examples.

### Vinyl Polymer

As the vinyl polymers used in the invention, there are, for example, an alkyl acrylate or alkyl methacrylate (examples of the alkyl include methyl, ethyl, n-propyl, isopropyl, n-butyl, isobutyl, t-butyl, 2-ethylhexyl, cyclohexyl, phenyl, benzyl or phenethyl); a hydroxyl group-containing monomer such as 2-hydroxyethyl acrylate, 2-hydroxyethyl methacrylate, 2-hydroxypropyl acrylate, or 2-hydroxypropyl methacrylate; an amido group-containing monomer such as acryl amide, methacryl amide, N-methylmethacryl amide, N-methylacryl amide, N-methylolacryl amide, N-methylolmethacryl amide, N,N-dimethylolacryl amide, N-methoxymethylacryl amide, N-methoxymethylmethacryl amide, or N-phenylacryl amide; an amino group-containing monomer such as N,N-diethylaminoethyl acrylate or N,N-diethylaminoethyl methacrylate; an epoxy group-containing monomer such as glycidyl acrylate or glycidyl methacrylate; and a carboxyl or its salt group-containing monomer such as acrylic or methacrylic acid or their salt (sodium, potassium or ammonium salt). As monomers other than other than the acrylic monomers, there are, for example, an epoxy group-containing monomer such as allyl glycidyl ether; a sulfo or its salt group-containing monomer such as styrene sulfonic acid, vinyl sulfonic acid or their salt (sodium, potassium or ammonium salt), a carboxyl or its salt group-containing monomer such as crotonic acid, itaconic acid, maleic acid, fumaric acid or their salt (sodium, potassium or ammonium salt); an anhydride monomer such as maleic anhydride or itaconic anhydride; vinyl isocyanate; allyl isocyanate; styrene; vinyltrisalkoxysilane; alkylmaleic acid monoester; alkylfumaric acid monoester; acrylonitrile; methacrylonitrile; alkylitaconic acid monoester; vinylidene chloride; vinyl acetate; and vinyl chloride. As the vinyl monomers used, an epoxy group-containing monomer such as glycidyl acrylate or glycidyl methacrylate is preferred.

The acryl resin preferably used in the invention is preferably in the form of polymer latex in view of environmental protection. Herein, the polymer latex is a water-insoluble polymer, which is dispersed in water or an aqueous dispersion medium in the form of particles. The polymer latex may be one in which a polymer is emulsified in a dispersion medium, one obtained by emulsion polymerization, one in which a polymer is dispersed in the form of micelles or one in which a polymer partially having a hydrophilic structure is molecularly dispersed. Polymer latexes are described in "Synthetic Resin Emulsion" (edited by T. Okuda and H. Inagaki, published by KOBUNSHI-KANKOKAI, 1978), "Application of Synthetic Latex" (edited by Sugimura et al., published by KOBUNSHI-KANKOKAI, 1993), and "Chemistry of Synthetic Latex" (S. Muroi, published by KOBUNSHI-KANKOKAI, 1970).

The polymer latex has an average particle size of preferably from 1 to 50000 nm, and more preferably from 5 to 1000 nm. The particle size distribution of the latex may be polydisperse or monodisperse.

The polymer latex may be a conventional polymer latex with a uniform structure or a core-shell type polymer latex. In the core-shell type polymer latex, one may be preferred in which a polymer constituting the core is different in glass transition temperature from a polymer constituting the shell.

The minimum film forming temperature (MFT) of the polymer latex used in the invention is preferably from -30 to 90 °C, and more preferably from 0 to 70 °C. In the invention, a film forming aid may be added to control the minimum film forming temperature. Such a film forming aid is called a plasticizer, and is an organic compound (usually an organic solvent), which lowers the minimum film forming temperature of the polymer latex. Such an organic compound is described, for example, in S. Muroi, "Gousei Latex no Kagaku (Chemistry of Synthesized Latex)", published by Koubunshi Kankoukai (1970). Vinyl Monomer-modified Polyester

As the polyester in the invention, a vinyl monomer-modified polyester is preferably used.

The vinyl monomer-modified polyester is one obtained by polymerizing a vinyl monomer dispersed in an aqueous solution containing a hydrophilic polyester copolymer. The dispersion solution thereof can be obtained for example by dissolving the hydrophilic polyester copolymer in hot water to obtain an aqueous hydrophilic polyester copolyester solution, dispersing a vinyl monomer in the resulting solution, and dispersion or emulsion polymerizing the vinyl monomer. In the invention, emulsion polymerization is preferably carried out.

As the vinyl monomer, the vinyl monomers described above can be used. Examples of the polymerization initiator include ammonium persulfate, potassium persulfate, sodium persulfate, and benzoyl peroxide. Among these, ammonium persulfate is preferred. Polymerization can be carried out without employing a surfactant, but it is possible to carry out polymerization employing a surfactant in order to secure polymerization stability. As the surfactant, a nonionic or anionic surfactant can be employed.

As the vinyl monomer, the vinyl monomer as described above can be used. The content ratio by weight of the vinyl monomer to the polyester in the vinyl monomer-modified polyester and in an admixture of the vinyl monomer and polyester is preferably from 50/50 to 3/97, more preferably from 30/70 to 5/95, and still more preferably from 20/80 to 10/90. The ratio falling outside the above range lowers an adhesion property of the vinyl monomer, on-press developability and printing durability and causes out of registration. As the vinyl polymer in the invention, ones prepared from the vinyl monomers as described above can be used.

### (Others)

The following inorganic particles can be employed for the subbing layer preferably used in the present invention. Examples of the inorganic material include silica, alumina, barium sulfate, calcium carbonate, titania, tin oxide, indium oxide, and talk. These particle shapes are not particularly limited, and any shape such as needle-like, spherical, platelike, or fracture-like shape can be used. The particle diameter is preferably 0.1 to 10 µm, more preferably 0.2 to 6 µm, and still more preferable 0.3 to 3 µm. The addition amount of particles is 0.1 to 50 mg per 1 m² of one surface, preferably 0.2 to 30 mg, and more preferably 0.3 to 20 mg.

Thickness of the subbing layer preferably used in the invention is preferably 0.05 to 0.50 µm in view of transparency and uneven coating (interference unevenness), and more preferably 0.10 to 0.30 µm. The thickness less than 0.05 µm cannot give an intended adhesion property, resulting in out of registration and lowering on-press developability and printing durability. The thickness exceeding 0.50 µm gives strong interference unevenness, which is commercially unacceptable.

As for the subbing layer, the coating liquid is coated onto either one surface or both surfaces of polyester film particularly before completing crystalline orientation during coating of a support, but it is preferable that the coating liquid is coated onto either one surface or both surfaces of polyester film in on line or off line after coating of a support.

As a coating method of the subbing layer, commonly known as appropriate coating-methods may be employed. It is preferable to apply the following method singly or in combination, for example, a kiss coating method, reverse coating method, die coating method, reverse kiss coating method, offset gravure coating method, the Meyer bar coating method, roller brush method, spray coating method, air-knife coating method, dip-coating method, and curtain coating method.

It is preferable to provide an antistatic layer for the subbing layer. The antistatic layer is made of an antistatic agent and a binder.

A metal oxide is preferably employed as an antistatic agent. Examples of such metal oxides preferably include ZnO, TiO₂, SnO₂, Al₂O₃, In₂O₃, SiO₂, MgO, BaO, MoO₂, and V₂O₅, as well as their multiple oxides. Specifically, from the viewpoint of miscibility with a binder, electrical conductivity and transparency, SnO₂ (being tin oxide) is preferred. As examples containing a different atom, Sb, Nb, or a halogen atom may be added to SnO₂. The added amount of the different atom is preferably in the range of 0.01 to 25 mol%, but the range of 0.1 to 15 mol% is specifically preferred.

Tin oxide is preferably in the form of an amorphous sol or crystalline particles. In the case of a water based coating, an amorphous sol is preferred, and in the case of a solvent based coating, it is in the form of crystalline particles. Specifically, from the viewpoint of ecology and handling during operation, the amorphous sol form of a water based coating is preferred.

A production method of the amorphous SnO₂ sol utilized for the present invention may be either of the following methods, a method to prepare by dispersing SnO₂ particles into an appropriate solvent, or a method to prepare via decomposition reaction of a solvent-soluble Sn compound in a solvent. The preparation via a decomposition reaction of a solvent-soluble Sn compound in the solvent will be described.

The solvent-soluble compound means a compound containing an oxoanion such as K₂SnO₃·3H₂O, water-soluble halide compound such as SnCl₄ or a compound having a structure represented by R'₂SnR₂, R₃SnX or R₂SnX₂ including, for example, organometallic compound such as (CH₃)₃SnCl· (pyridine), (C₄H₉)₂Sn(O₂CC₂H₅)₂ and an oxo-salt such as Sn(SO₄)₂·2H₂O. Methods for preparing a SnO₂ sol using the solvent-soluble Sn compound include a physical method by dissolving in a solvent, followed by applying heat or pressure, chemical method by oxidation, reduction or hydrolysis, and a method of preparing a SnO₂ sol via an intermediate. A SnO₂ sol preparation method described in Japanese Patent Examined Publication No. 35-6616 will be described as an example. SnCl₄ is first dissolved in distilled water of 100 times in capacity, and a precipitate of Sn(OH)₄ is prepared as an intermediate. Ammonia water is added into this product so as to be mildly alkaline, and colloidal SnO₂ sol can be prepared subsequently by heating up until ammonia odor does not smell at all.

Although water is employed as a solvent in the above example, various solvents including an alcohol solvent such as methanol, ethanol or isopropanol; an ether solvent such as tetrahydrofuran, dioxane or diethylether; an aliphatic organic solvent such as hexane or heptane; or an aromatic organic solvent such as benzene or pyridine can be used according to kinds of Sn compounds. The present invention is not limited to the solvents, but water or alcohols are preferably used.

On the other hand, crystalline particles are described in detail in Japanese Patent O.P.I. Publication Nos. 56-143430 and 60-258541. Production methods of these electrically conductive metal oxide particles may be any one of the following methods or a combination of them. The first method is one in which metal oxide particles are prepared by baking, after which the particles are heat treated under the presence of different kinds of atoms; the second is that different kinds of atoms are presented during preparation of metal oxide particles while baking; and the third being oxygen defect is introduced by a decrease of oxygen concentration during baking.

The average particle diameter of the primary particles employed in the present invention is 0.001 to 0.5 µm, but preferably 0.001 to 0.2 µm. The solid content coverage of the metal oxide employed in this invention is 0.05 to 2 g, but preferably 0.1 to 1 g. Further, the volume fraction of metal oxide in the antistatic layer of this invention is 8 to 40% by volume, but preferably 10 to 35% by volume. The above range may vary due to color, form and composition of metal oxide particles, but in view of transparency and electrical conductivity, the above range is preferred.

Preferable examples of binder also include polyester, acryl-modified polyester, polyurethane, acryl resin, vinyl resin, vinylidene chloride resin, polyethylene imine vinylidene resin, polyethylene imine, polyvinyl alcohol, modified polyvinyl alcohol, cellulose ester and gelatin.

The layer in the invention dissolving in an alkali solution with a pH of from 9 to 12 provided on a plastic support facilitates separation and collection of the plastic support therefrom and recycling of the support. In order to form a layer dissolving in an alkali solution with a pH of from 9 to 12 on the plastic support, materials dissolving in an alkali solution with a pH of from 9 to 12 are preferably used.

The image formation layer in the invention preferably contains heat melting particles and/or heat fusible particles.

The heat melting particles preferably used in the invention are particularly particles having a low melt viscosity, which are particles formed from materials generally classified into wax. The materials preferably have a softening point of from 40° C to 120° C and a melting point of from 60° C to 150° C, and more preferably a softening point of from 40° C to 100° C and a melting point of from 60° C to 120° C. The melting point less than 60° C has a problem in storage stability and the melting point exceeding 300° C lowers ink receptive sensitivity.

Materials usable include paraffin wax, polyolefin wax, polyethylene wax, microcrystalline wax, and waxes of fatty acids or their derivatives. The molecular weight thereof is approximately from 800 to 10,000. A polar group such as a hydroxyl group, an ester group, a carboxyl group, an aldehyde group and a peroxide group may be introduced into the wax by oxidation to increase the emulsification ability. Moreover, stearoamide, linolenamide, laurylamide, myristylamide, hardened cattle fatty acid amide, parmitylamide, oleylamide, rice bran oil fatty acid amide, palm oil fatty acid amide, a methylol compound of the above-mentioned amide compounds, methylenebissteastearoamide and ethylenebissteastearoamide may be added to the wax to lower the softening point or to raise the working efficiency. A cumarone-indene resin, a rosin-modified phenol resin, a terpene-modified phenol resin, a xylene resin, a ketone resin, an acryl resin, an ionomer and a copolymer of these resins may also be usable.

Among them, polyethylene, microcrystalline, fatty acid esters, fatty acid amides and higher fatty acids are preferred. A high sensitive image formation can be performed since these materials each have a relative low melting point and a low melt viscosity. These materials each have a lubrication ability. Accordingly, even when a shearing force is applied to the surface layer of the printing plate precursor, the layer damage is minimized, and resistance to stain which may be caused by scratch is further enhanced.

The heat melting particles are preferably dispersible in water. The average particle size thereof is preferably from 0.01 to 10 µm, and more preferably from 0.1 to 3 µm. When a layer containing heat melting particles having an average particle size less than 0.01 µm is coated on a porous hydrophilic layer described later, the particles may enter the pores of the hydrophilic layer or the valleys between the neighboring two peaks on the hydrophilic layer surface, resulting in insufficient on-press developability, and in stain occurrence at backgrounds. On the other hand, heat melting particles having an average particle size exceeding 10 µm may result in lowering of dissolving power.

The composition of the heat melting particles may be continuously varied from the interior to the surface of the particles. The particles may be covered with a different material.

Known microcapsule production method or sol-gel method can be applied for covering the particles. The heat melting particle content of the layer is preferably 1 to 90% by weight, and more preferably 5 to 80% by weight based on the total layer weight.

The heat fusible particles in the invention include thermoplastic hydrophobic polymer particles. Although there is no specific limitation to the upper limit of the softening point of the thermoplastic hydrophobic polymer, the softening point is preferably lower than the decomposition temperature of the polymer. The weight average molecular weight (Mw) of the thermoplastic hydrophobic polymer is preferably within the range of from 10,000 to 1,000,000.

Examples of the polymer consisting the polymer particles include a diene (co)polymer such as polypropylene, polybutadiene, polyisoprene or an ethylene-butadiene copolymer; a synthetic rubber such as a styrene-butadiene copolymer, a methyl methacrylate-butadiene copolymer or an acrylonitrile-butadiene copolymer; a (meth)acrylate (co)polymer or a (meth)acrylic acid (co)polymer such as polymethyl methacrylate, a methyl methacrylate-(2-ethylhexyl)acrylate copolymer, a methyl methacrylate-methacrylic acid copolymer, or a methyl acrylate-(N-methylolacrylamide); polyacrylonitrile; a vinyl ester (co)polymer such as a polyvinyl acetate, a vinyl acetate-vinyl propionate copolymer and a vinyl acetate-ethylene copolymer, or a vinyl acetate-2-hexylethyl acrylate copolymer; and polyvinyl chloride, polyvinylidene chloride, polystyrene and a copolymer thereof. Among them, the (meth)acrylate polymer, the (meth)acrylic acid (co)polymer, the vinyl ester (co)polymer, the polystyrene and the synthetic rubbers are preferably used.

The polymer particles may be prepared from a polymer synthesized by any known method such as an emulsion polymerization method, a suspension polymerization method, a solution polymerization method and a gas phase polymerization method. The particles of the polymer synthesized by the solution polymerization method or the gas phase polymerization method can be produced by a method in which an organic solution of the polymer is sprayed into an inactive gas and dried, and a method in which the polymer is dissolved in a water-immiscible solvent, then the resulting solution is dispersed in water or an aqueous medium and the solvent is removed by distillation. In both of the methods, a surfactant such as sodium lauryl sulfate, sodium dodecylbenzenesulfate or polyethylene glycol, or a water-soluble resin such as poly(vinyl alcohol) may be optionally used as a dispersing agent or stabilizing agent.

The heat fusible particles are preferably dispersible in water. The average particle size thereof is preferably from 0.01 to 10 µm, and more preferably from 0.1 to 3 µm. When a layer containing heat fusible particles having an average particle size less than 0.01 µm is coated on a porous hydrophilic layer described later, the particles may enter the pores of the hydrophilic layer or the valleys between the neighboring two peaks on the hydrophilic layer surface, resulting in insufficient on-press developability, and in stain occurrence at backgrounds. On the other hand, heat fusible particles having an average particle size exceeding 10 µm may result in lowering of dissolving power.

Further, the composition of the heat fusible particles may be continuously varied from the interior to the surface of the particles. The particles may be covered with a different material.

As a covering method, known methods such as a microcapsule method and a sol-gel method are usable. The heat fusible particle content of the image formation layer is preferably from 1 to 90% by weight, and more preferably from 5 to 80% by weight based on the total weight of the image formation layer.

The image formation layer in the invention can further contain a water soluble material. When the image formation layer at unexposed portions is removed on a press with dampening water or ink, the water soluble material makes it possible to easily remove the layer.

Regarding the water soluble material, those described above as water soluble materials to be contained in the hydrophilic layer can be used. The image formation layer in the invention preferably contains saccharides, and more preferably contains oligosaccharides.

Since the oligosaccharides are easily dissolved in water, removal on a press of unexposed portions of an oligosaccharide-containing layer can be easily carried out dissolving the saccharide in water. The removal does not require a specific system, and can be carried out conducting the same manner as in the beginning of printing of a conventional PS plate, which does not increase loss of prints at the beginning of printing. Use of the oligosaccharide does not lower hydrophilicity of the hydrophilic layer and can maintain good printing performance of the hydrophilic layer.

The oligosaccharide is a water-soluble crystalline substance generally having a sweet taste, which is formed by a dehydration condensation reaction of plural monosaccharide molecules. The oligosaccharide is one kind of o-glycoside having a saccharide as the aglycon. The oligosaccharide is easily hydrolyzed by an acid to form a monosaccharide, and is classified according to the number of monosaccharide molecules of the resulting hydrolysis compounds, for example, into disaccharide, trisaccharide, tetrasaccharide, and pentasscharide. The oligosaccharide referred to in the invention means di- to deca-saccharides.

The oligosaccharide is classified into a reducing oligosaccharide and a non-reducing oligosaccharide according to presence or absence of a reducing group in the molecule. The oligosaccharide is also classified into a homo-oligosaccharide composed of the same kind of monosaccharide and a hetero-oligosaccharide composed of two or more kinds of monosaccharides.

The oligosaccharide naturally exists in a free state or a glycoside state. Moreover, various oligosaccharides are formed by glycosyl transition by action of an enzyme.

The oligosaccharide frequently exists in a hydrated state in an ordinary atmosphere. The melting points of the hydrated one and anhydrous one are different from each other.

In the invention, the layer containing a saccharide is preferably formed coating an aqueous coating solution containing the saccharide on a support. When an oligossccharide in the layer formed from the aqueous coating solution is one capable of forming a hydrate, the melting point of the oligosaccharide is that of its hydrate. Since the oligosaccharides, having a relatively low melting point, also melt within the temperature range at which heat melting particles melt or heat fusible particles fuse, they do not cause image formation inhibition resulting from permeation of the heat melting particles into the porous hydrophilic layer and/or fusion adhesion of the heat fusible particles to the hydrophilic layer.

Among the oligosaccharides, trehalose with comparatively high purity is available on the market, and has an extremely low hygroscopicity, although it has high water solubility, providing excellent storage stability and excellent development property on a printing press.

When oligosaccharide hydrates are heat melted to remove the hydrate water and solidified, the oligosaccharide is in a form of anhydride for a short period after solidification. Trehalose is characterized in that a melting point of trehalose anhydride is not less than 100° C higher that that of trehalose hydrate. This characteristics provides a high melting point and reduced heat fusibility at exposed portions of the trehalose-containing layer immediately after heat-fused by infrared ray exposure and re-solidified, preventing image defects at exposure such as banding from occurring.

Among the oligosaccharides, trehalose is especially preferred. The oligosaccharide content of the layer is preferably from 1 to 90% by weight, and more preferably from 10 to 80% by weight, based on the total weight of the layer.

Image formation for the printing method of the invention can be carried out by applying heat, and is carried out preferably by infrared laser exposure. Exposure applied in the invention is preferably scanning exposure, which is carried out employing a laser which can emit light having a wavelength of infrared and/or near-infrared regions, that is, a wavelength of from 700 to 1500 nm. As the laser, a gas laser can be used, but a semi-conductor laser, which emits light having a near-infrared region wavelength, is preferably used.

A device suitable for the exposure may be any device capable of forming an image on the printing plate precursor according to image signals from a computer employing a semi-conductor laser.

Generally, the following three exposure processes are mentioned. (1) A process in which a plate precursor provided on a fixed horizontal plate is scanning exposed in two dimensions, employing one or several laser beams.

(2) A process in which the surface of a plate precursor provided along the inner peripheral wall of a fixed cylinder is subjected to scanning exposure in the rotational direction (in the main scanning direction) of the cylinder, employing one or several lasers located inside the cylinder, moving the lasers in the normal direction (in the sub-scanning direction) to the rotational direction of the cylinder.

(3) A process in which the surface of a plate precursor provided along the outer peripheral wall of a fixed cylinder is subjected to scanning exposure in the rotational direction (in the main scanning direction) of the cylinder, employing one or several lasers located inside the cylinder, moving the lasers in the normal direction (in the sub-scanning direction) to the rotational direction of the cylinder.

In the invention, the process (3) above is preferable, and especially preferable when a printing plate precursor mounted on a plate cylinder of a printing press is scanning exposed.

In the printing method of the invention, imagewise exposure is carried out as above and development is carried out on a planographic printing press employing dampening water or both dampening water and printing ink, followed by printing. As the planographic printing press, a commercially available planographic printing press equipped with a dampening water supply device can be used.

The image formation layer in the invention is preferably one capable of being subjected to on-press development. On-press development refers to one carried out employing dampening water or both dampening water and printing ink (wherein an image formation layer at non-image portions are removed), as in the printing method described above.

The layer in the invention separated from the plastic support with an alkali solution with a pH of from 9 to 12 is a layer separated from the plastic support by its contact with the alkali solution. As the contact method, there is a method in which the layer is immersed in the alkali solution or a method in which in the alkali solution is sprayed on the layer.

The alkali solution is preferably an alkali solution containing an inorganic alkali agent. Examples of the alkali agent include sodium hydroxide and potassium hydroxide.

The planographic printing plate material of the invention has a hydrophilic layer on a plastic support. It is preferred that the planographic printing plate material of the invention has a hydrophilic layer on a plastic support and an image formation layer on the hydrophilic layer.

The hydrophilic layer preferably contains a material forming a hydrophilic matrix.

The material used in the hydrophilic layer of the planographic printing plate material of the invention will be explained below.

The material forming a hydrophilic matrix is preferably a metal oxide, and more preferably metal oxide particles.

Examples of the metal oxide particles include colloidal silica particles, an alumina sol, a titania sol and another metal oxide sol. The metal oxide particles may have any shape such as spherical, needle-like, and feather-like shape. The average particle diameter is preferably from 3 to 100 nm, and plural kinds of metal oxide each having a different size may be used in combination.

The surface of the particles may be subjected to surface treatment.

The metal oxide particles can be used as a binder, utilizing its layer forming ability. The metal oxide particles are suitably used in a hydrophilic layer since they minimize lowering of the hydrophilicity of the layer as compared with an organic compound binder. Among the above-mentioned, colloidal silica is particularly preferred. The colloidal silica has a high layer forming ability under a drying condition with a relative low temperature, and can provide a good layer strength.

It is preferred that the colloidal silica used in the invention is necklace-shaped colloidal silica or colloidal silica having an average particle diameter of not more than 20 nm, and preferably from 3 to 20 nm, each being described later. Further, it is preferred that the colloidal silica provides an alkaline colloidal silica solution as a colloid solution.

The necklace-shaped colloidal silica to be used in the invention is a generic term of an aqueous dispersion system of spherical silica having a primary particle diameter of the order of nm.

The necklace-shaped colloidal silica to be used in the invention means a "pearl necklace-shaped" colloidal silica formed by connecting spherical colloidal silica particles each having a primary particle diameter of from 10 to 50 µm so as to attain a length of from 50 to 400 nm.

The term of "pearl necklace-shaped" means that the image of connected colloidal silica particles is like to the shape of a pearl necklace.

The bonding between the silica particles forming the necklace-shaped colloidal silica is considered to be -Si-O-Si-, which is formed by dehydration of -SiOH groups located on the surface of the silica particles. Concrete examples of the necklace-shaped colloidal silica include Snowtex-PS series produced by Nissan Kagaku Kogyo, Co., Ltd.

As the products, there are Snowtex-PS-S (the average particle diameter in the connected state is approximately 110 nm), Snowtex-PS-M (the average particle diameter in the connected state is approximately 120 nm) and Snowtex-PS-L (the average particle diameter in the connected state is approximately 170 nm). Acidic colloidal silicas corresponding to each of the above-mentioned are Snowtex-PS-S-O, Snowtex-PS-M-O and Snowtex-PS-L-O, respectively.

The necklace-shaped colloidal silica is preferably used in a hydrophilic layer as a porosity providing material for hydrophilic matrix phase, and porosity and strength of the layer can be secured by its addition to the layer. Among them, the use of Snowtex-PS-S, Snowtex-PS-M or Snowtex-PS-L, each being alkaline colloidal silica particles, is particularly preferable since the strength of the hydrophilic layer is increased and occurrence of background contamination is inhibited even when a lot of prints are printed.

It is known that the binding force of the colloidal silica particles is become larger with decrease of the particle diameter. The average particle diameter of the colloidal silica particles to be used in the invention is preferably not more than 20 nm, and more preferably 3 to 15 nm. As above-mentioned, the alkaline colloidal silica particles show the effect of inhibiting occurrence of the background contamination. Accordingly, the use of the alkaline colloidal silica particles is particularly preferable.

Examples of the alkaline colloidal silica particles having the average particle diameter within the foregoing range include Snowtex-20 (average particle diameter: 1.0 to 20 nm), Snowtex-30 (average particle diameter: 10 to 20 nm), Snowtex-40 (average particle diameter: 10 to 20 nm), Snowtex-N (average particle diameter: 10 to 20 nm), Snowtex-S (average particle diameter: 8 to 11 nm) and Snowtex-XS (average particle diameter: 4 to 6 nm), each produced by Nissan Kagaku Co., Ltd.

The colloidal silica particles having an average particle diameter of not more than 20 nm, when used together with the necklace-shaped colloidal silica as described above, is particularly preferred, since appropriate porosity of the layer is maintained and the layer strength is further increased. The ratio of the colloidal silica particles having an average particle diameter of not more than 20 nm to the necklace-shaped colloidal silica is preferably from 95/5 to 5/95, more preferably from 70/30 to 20/80, and most preferably from 60/40 to 30/70.

The hydrophilic layer of the printing plate material in the invention can contain porous metal oxide particles with a particle diameter of less than 1 µm as porosity providing material. Examples of the porous metal oxide particles include porous silica particles, porous aluminosilicate particles or zeolite particles as described later.

The porous silica particles are ordinarily produced by a wet method or a dry method. By the wet method, the porous silica particles can be obtained by drying and pulverizing a gel prepared by neutralizing an aqueous silicate solution, or pulverizing the precipitate formed by neutralization. By the dry method, the porous silica particles are prepared by combustion of silicon tetrachloride together with hydrogen and oxygen to precipitate silica.

The porous aluminosilicate particles can be prepared by the method described in, for example, JP O.P.I. No. 10-71764. Thus prepared aluminosilicate particles are amorphous complex particles synthesized by hydrolysis of aluminum alkoxide and silicon alkoxide as the major components. The particles can be synthesized so that the ratio of alumina to silica in the particles is within the range of from 1 : 4 to 4 : 1.

Complex particles composed of three or more components prepared by an addition of another metal alkoxide may also be used in the invention. In such a particle, the porosity and the particle diameter can be controlled by adjustment of the production conditions.

The porosity of the particles is preferably not less than 1.0 ml/g, more preferably not less than 1.2 ml/g, and most preferably of from 1.8 to 2.5 ml/g, in terms of pore volume before the dispersion.

The pore volume is closely related to water retention of the coated layer. As the pore volume increases, the water retention is increased, stain is difficult to occur, and water tolerance is high. Particles having a pore volume of more than 2.5 ml/g are brittle, resulting in lowering of durability of the layer containing them. Particles having a pore volume of less than 0.5 ml/g may provide insufficient printing property. As porosity providing material, zeolite can be used.

Zeolite is a crystalline aluminosilicate, which is a porous material having voids of a regular three dimensional net work structure and having a pore size of 0.3 to 1 nm. Natural and synthetic zeolites are expressed by the following formula.

(M1, M2 1/2)ₘ(AlₘSiₙO₂₍ₘ₊ₙ₎)·xH₂O

In the above, M1 and M2 are each exchangeable cations. Examples of M1 include Li⁺, Na⁺, K⁺, Tl⁺, Me₄N⁺ (TMA), Et₄N⁺ (TEA), Pr₄N⁺ (TPA), C₇H₁₅N²⁺, and C₈H₁₆N⁺, and examples of M2 include Ca²⁺, Mg²⁺, Ba²⁺, Sr²⁺ and (C₈H₁₈N)₂²⁺.

Relation of n and m is n ≥ m, and consequently, the ratio of m/n, or that of Al/Si is not more than 1. A higher Al/Si ratio shows a higher content of the exchangeable cation, and a higher polarity, resulting in higher hydrophilicity. The Al/Si ratio is within the range of preferably from 0.4 to 1.0, and more preferably 0.8 to 1.0. x is an integer.

Synthetic zeolite having a stable Al/Si ratio and a sharp particle diameter distribution is preferably used as the zeolite particles to be used in the invention. Examples of such zeolite include Zeolite A: Na₁₂(Al₁₂Si₁₂O₄₈)·27H₂O; Al/Si = 1.0, Zeolite X: Na₈₆(Al₈₆Si₁₀₆O₃₈₄) ·264H₂O; Al/Si = 0.811, and Zeolite Y: Na₅₆(Al₅₆Si₁₃₆O₃₈₄)·250H₂O; Al/Si = 0.412. Hydrophilicity of the hydrophilic layer itself is greatly raised by incorporation of the porous zeolite particles having an Al/Si ratio within the range of from 0.4 to 1.0 in the hydrophilic layer, whereby contamination in the course of printing is inhibited and the water retention latitude is also increased. Further, contamination caused by a finger mark is also greatly reduced. When Al/Si is less than 0.4, the hydrophilicity is insufficient and the above-mentioned improving effects are lowered.

The hydrophilic matrix of the printing plate material in the invention can contain layer structural clay mineral particles as a metal oxide. Examples of the layer structural clay mineral particles include a clay mineral such as kaolinite, halloysite, talk, smectite such as montmorillonite, beidellite, hectorite and saponite, vermiculite, mica and chlorite; hydrotalcite; and a layer structural polysilicate such as kanemite, makatite, ilerite, magadiite and kenyte. Among them, ones having a higher electric charge density of the unit layer are higher in the polarity and in the hydrophilicity. Preferable charge density is not less than 0.25, more preferably not less than 0.6. Examples of the layer structural mineral particles having such a charge density include smectite having a negative charge density of from 0.25 to 0.6 and bermiculite having a negative charge density of from 0.6 to 0.9. Synthesized fluorinated mica is preferable since one having a stable quality, such as the particle diameter, is available. Among the synthesized fluorinated mica, swellable one is preferable and one freely swellable is more preferable.

An intercalation compound of the foregoing layer structural mineral particles such as a pillared crystal, or one treated by an ion exchange treatment or a surface treatment such as a silane coupling treatment or a complication treatment with an organic binder is also usable.

The planar structural mineral particles are preferably in the plate form, and have an average particle diameter (an average of the largest particle length) of less than 1 µm, and an average aspect ratio (the largest particle length/the particle thickness) of preferably not less than 50, in a state contained in the layer including the case that the particles are subjected to a swelling process and a dispersing layer-separation process. When the particle diameter is within the foregoing range, continuity to the parallel direction, which is a trait of the layer structural particle, and softness, are given to the coated layer so that a strong dry layer in which a crack is difficult to be formed can be obtained. The coating solution containing the layer structural clay mineral particles in a large amount can minimize particle sedimentation due to a viscosity increasing effect. The particle diameter falling outside the above range may produce non-uniformity in the coated layer, resulting in lowering strength of the layer. The aspect ratio less than the lower limit of the above range reduces the number of the particles relative to the addition amount, and lowers viscosity increasing effect, resulting in lowering of particle sedimentation resistance.

The content of the layer structural clay mineral particles is preferably from 0.1 to 30% by weight, and more preferably from 1 to 10% by weight based on the total weight of the layer. Particularly, the addition of the swellable synthesized fluorinated mica or smectite is effective if the adding amount is small. The layer structural clay mineral particles may be added in the form of powder to a coating liquid, but it is preferred that gel of the particles which is obtained by being swelled in water, is added to the coating liquid in order to obtain a good dispersity according to an easy coating liquid preparation method which requires no dispersion process comprising dispersion due to media.

An aqueous solution of a silicate is also usable as another additive to the hydrophilic matrix phase in the invention. An alkali metal silicate such as sodium silicate, potassium silicate or lithium silicate is preferable, and the ratio SiO₂/M₂O is preferably selected so that the pH value of the coating liquid after addition of the silicate does not exceed 13 in order to prevent dissolution of the porous metal oxide particles or the colloidal silica particles. An inorganic polymer prepared from a metal alkoxide by a sol-gel method or an inorganic-organic hybrid polymer can be used. Known methods described in S. Sakka "Application of Sol-Gel Method" or in the publications cited in the above publication can be applied to prepare the inorganic polymer or the inorganic-organic hybrid polymer by the sol-gel method.

The hydrophilic layer may contain a water soluble resin. Examples of the water soluble resin include polysaccharides, polyethylene oxide, polypropylene oxide, polyvinyl alcohol, polyethylene glycol (PEG), polyvinyl ether, a styrene-butadiene copolymer, a conjugation diene polymer latex of methyl methacrylate-butadiene copolymer, an acryl polymer latex, a vinyl polymer latex, polyacrylamide, and polyvinyl pyrrolidone. In the invention, polysaccharides are preferred. As the polysaccharide, starches, celluloses, polyuronic acid and pullulan can be used. Among them, a cellulose derivative such as a methyl cellulose salt, a carboxymethyl cellulose salt or a hydroxyethyl cellulose salt is preferable, and a sodium or ammonium salt of carboxymethyl cellulose is more preferable.

These polysaccharides can form a preferred surface shape of the hydrophilic layer.

The surface of the hydrophilic layer preferably has a convexoconcave structure having a pitch of from 0.1 to 20 µm such as the grained aluminum surface of an aluminum PS plate.

The water retention ability and the image maintaining ability are raised by such a convexoconcave structure of the surface. Such a convexoconcave structure can also be formed by adding in an appropriate amount a filler having a suitable particle diameter to the coating liquid of the hydrophilic layer. However, the convexoconcave structure is preferably formed by coating a coating liquid for the hydrophilic layer containing the alkaline colloidal silica and the water-soluble polysaccharide so that the phase separation occurs at the time of drying the coated liquid, whereby a structure is obtained which provides a good printing performance. The shape of the convexoconcave structure such as the pitch and the surface roughness thereof can be suitably controlled by the kinds and the adding amount of the alkaline colloidal silica particles, the kinds and the adding amount of the water-soluble polysaccharide, the kinds and the adding amount of another additive, a solid concentration of the coating liquid, a wet layer thickness or a drying condition.

It is preferred that the water soluble resin is contained in the hydrophilic layer in such a state that at least a part of the water soluble resin is capable of being dissolved in water. This is because even the water soluble resin, when cross-linked with a cross-linking agent, is water insoluble, which lowers its hydrophilicity and printing properties.

A cationic resin may also be contained in the hydrophilic layer. Examples of the cationic resin include a polyalkylene-polyamine such as a polyethyleneamine or polypropylenepolyamine or its derivative, an acryl resin having a tertiary amino group or a quaternary ammonium group and diacrylamine. The cationic resin may be added in a form of fine particles. Examples of such particles include the cationic microgel described in Japanese Patent O.P.I. Publication No. 6-161101.

A water-soluble surfactant may be added for improving the coating ability of the coating liquid for the hydrophilic layer in the invention. A silicon atom-containing surfactant and a fluorine atom-containing surfactant are preferably used. The silicon atom-containing surfactant is especially preferred in that it minimizes printing contamination. The content of the surfactant is preferably from 0.01 to 3% by weight, and more preferably from 0.03 to 1% by weight based on the total weight of the hydrophilic layer (or the solid content of the coating liquid).

The hydrophilic layer in the invention can contain a phosphate. Since a coating liquid for the hydrophilic layer is preferably alkaline, the phosphate to be added to the hydrophilic layer is preferably sodium phosphate or sodium monohydrogen phosphate. The addition of the phosphate provides improved reproduction of dots at shadow portions. The content of the phosphate is preferably from 0.1 to 5% by weight, and more preferably from 0.5 to 2% by weight in terms of amount excluding hydrated water.

The hydrophilic layer can contain a light-to-heat conversion material described later. The light-to-heat conversion material, when particles, is preferably ones with a particle diameter of less than 1 µm.

In the invention, the hydrophilic layer preferably contains inorganic particles with a particle size of not less than 1 µm or particles covered with inorganic materials.

Any of a porous substance, a non-porous substance, organic resin particles or inorganic particles can be used. Examples of the inorganic fillers include silica, alumina, zirconia, titania, carbon black, graphite, TiO₂, BaSO₄ ZnS, MgCO₃, CaCO₃, ZnO, CaO, WS₂, MoS₂, MgO, SnO₂, Al₂O₃, α-Fe₂O₃, α-FeOOH, SiC, CeO₂, BN, SiN, MoC, BC, WC, titanium carbide, corundum, artificial diamond, garnet, garnet, quartz, silica rock, tripoli, diatomite, and dolomite. Examples of the organic fillers include polyethylene fine particles, fluororesin particles, guanamine resin particles, acrylic resin particles, silicone resin particles, melamine resin particles, and the like. As the inorganic material coated fillers, there are, for example, particles in which organic particles such as particles of PMMA or polystyrene as core particles are coated with inorganic particles with a particle diameter smaller that that of the core particles. The particle diameter of the inorganic particles is preferably from 1/10 to 1/100 of that of the core particles. As the inorganic particles, particles of known metal oxides such silica, alumina, titania and zirconia can be used. Various coating methods can be used, but a dry process is preferred which core particles collide with particles for coating at high speed in air as in a hybridizer to push the particles for coating in the core particle surface and fix, whereby the core particles are coated with the particles for coating.

Particles, in which the organic core particles are plated with metal, can be used. As such particles, there is, for example, "Micropearl AU", produced by SEKISUI KAGAKU KOGYO Co, Ltd., in which resin particles are plated with gold.

In the invention, any fillers are effective as long as they meet the scope of the invention. Particularly in order to minimize particle sedimentation in a coating liquid, porous inorganic fillers such as porous silica particles or porous aluminosilicate particles, or fillers covered with porous inorganic particles are preferably used. The particle diameter of the fillers is preferably from 1 to 12 µm, more preferably from 1.5 to 8 µm, and still more preferably from 2 to 6 µm.

The particles diameter exceeding 12 µm results in problem of lowering dissolution of formed images or contaminating a blanket.

The particles described above with a particle diameter of not less than 1 µm are contained in the hydrophilic layer in an amount of preferably from 1 to 50% by weight, and more preferably from 5 to 40% by weight.

In the hydrophilic layer, the content of carbon-containing materials such as organic resins or carbon black is preferably low in increasing hydrophilicity. The content of the carbon-containing materials in the hydrophilic layer is preferably less than 9% by weight, and more preferably less than 5% by weight.

The hydrophilic layer may be plural, and an under hydrophilic layer may be provided under the hydrophilic layer described above.

When the under layer is provided, materials used in the under layer include the same materials as in the hydrophilic layer described above.

The under layer, when it is porous, is less advantageous. Since the under layer is preferably non-porous in view of strength of the layer, the porosity providing agent content of the under layer is preferably lower than that of the hydrophilic layer. It is more preferable that the under layer contains no porosity providing agent.

The content of the particles having a particle diameter of not less than 1 µm described above in the under layer is preferably from 1 to 50% by weight, and more preferably from 5 to 40% by weight.

Like the hydrophilic layer, the content of carbon-containing materials such as the organic resins or carbon black in the under layer is preferably lower in increasing hydrophilicity of the under layer. The total content of these materials in the under layer is preferably less than 9% by weight, and more preferably less than 5% by weight.

The hydrophilic layer, under layer or image formation layer can contain a light-to-heat conversion material described later.

In the invention, the hydrophilic layer can contain the following metal oxides as the light-to-heat conversion material.

Materials having black color in the visible regions or materials, which are electro-conductive or semi-conductive, can be used.

Examples of the former include black iron oxide and black complex metal oxides containing at least two metals.

Examples of the latter include Sb-doped SnO₂ (ATO), Sn-added In₂O₃ (ITO), TiO₂, TiO prepared by reducing TiO₂ (titanium oxide nitride, generally titanium black). Particles prepared by covering a core material such as BaSO₄, TiO₂ 9Al₂O₃·2B₂O and K₂O·nTiO₂ with these metal oxides is usable. These oxides are particles having a particle diameter of not more than 0.5 µm, preferably not more than 100 nm, and more preferably not more than 50 nm.

As these light-to-heat conversion materials, black iron oxide or black complex metal oxides containing at least two metals are more preferred.

Examples of the black complex metal oxides include complex metal oxides comprising at least two selected from A1, Ti, Cr, Mn, Fe, Co, Ni, Cu, Zn, Sb, and Ba. These can be prepared according to the methods disclosed in Japanese Patent O.P.I. Publication Nos. 9-27393, 9-25126, 9-237570, 9-241529 and 10-231441.

The complex metal oxide used in the invention is preferably a complex Cu-Cr-Mn type metal oxide or a Cu-Fe-Mn type metal oxide. The Cu-Cr-Mn type metal oxides are preferably subjected to the treatment disclosed in Japanese Patent O.P.I. Publication Nos. 8-27393 in order to reduce isolation of a 6-valent chromium ion. These complex metal oxides have a high color density and a high light heat conversion efficiency as compared with another metal oxide.

The primary average particle diameter of these complex metal oxides is preferably from 0.001 to 1.0 µm, and more preferably from 0.01 to 0.5 µm. The primary average particle diameter of from 0.001 to 1.0 µm improves a light heat conversion efficiency relative to the addition amount of the particles, and the primary average particle diameter of from 0.05 to 0.5 µm further improves a light heat conversion efficiency relative to the addition amount of the particles. The light heat conversion efficiency relative to the addition amount of the particles depends on a dispersity of the particles, and the well-dispersed particles have a high light heat conversion efficiency.

Accordingly, these complex metal oxide particles are preferably dispersed according to a known dispersing method, separately to a dispersion liquid (paste), before being added to a coating liquid for the particle containing layer. The metal oxides having a primary average particle diameter of less than 0.001 are not preferred since they are difficult to disperse. A dispersant is optionally used for dispersion. The addition amount of the dispersant is preferably from 0.01 to 5% by weight, and more preferably from 0.1 to 2% by weight, based on the weight of the complex metal oxide particles.

The content of the complex metal oxide in the hydrophilic layer is preferably from 20% by weight to less than 40% by weight, more preferably from 25% by weight to less than 39% by weight, and still more preferably from 25% by weight to less than 30% by weight, based on the total solid amount of hydrophilic layer. The content less than 20% by weight of the oxide provides poor sensitivity, while the content not less than 40% by weight of the oxide produces ablation scum due to ablation. The hydrophilic layer or image formation layer in the invention can contain the following infrared absorbing dye as a light-to-heat conversion material.

Examples of the infrared absorbing dye include a general infrared absorbing dye such as a cyanine dye, a chloconium dye, a polymethine dye, an azulenium dye, a squalenium dye, a thiopyrylium dye, a naphthoquinone dye or an anthraquinone dye, and an organometallic complex such as a phthalocyanine compound, a naphthalocyanine compound, an azo compound, a thioamide compound, a dithiol compound or an indoaniline compound. Exemplarily, the light-to-heat conversion materials include compounds disclosed in Japanese Patent O.P.I. Publication Nos. 63-139191, 64-33547, 1-160683, 1-280750, 1-293342, 2-2074, 3-26593, 3-30991, 3-34891, 3-36093, 3-36094, 3-36095, 3-42281, 3-97589 and 3-103476. These compounds may be used singly or in combination.

The content of the infrared absorbing dye in the image formation layer is preferably from 0.1% by weight to less than 10% by weight, more preferably from 0.3% by weight to less than 7% by weight, and still more preferably from 0.5% by weight to less than 6% by weight, based on the total solid amount of hydrophilic layer. As is described above, the content less than 0.1% by weight of the oxide provides poor sensitivity, while the content not less than 10% by weight of the oxide produces ablation scum due to ablation.

In the printing plate material of the invention, it is preferred that at least one back coat layer is provided on the surface of the support opposite the image formation layer, in order to improve handling properties and minimize change in physical properties during storage. The back coat layer preferably contains a hydrophilic binder. When the support surface is hydrophobic, it may be a layer containing a water dispersible resin (polymer latex) disclosed in paragraphs (00339 through (0038) of Japanese Patent O.P.I. Publication Nos. 2002-258469.

The hydrophilic binder may be any as long as it exhibits hydrophilicity, and examples of the hydrophilic binder include resins having, as a hydrophilic group, a hydroxyl group such as polyvinyl alcohol (PVA), cellulose resins (methylcellulose MC, ethylcellulose EC, hydroxyethylcellulose HEC, carboxymethylcellulose CMC), chitins, or starch; resins having an ether bond such as polyethylene oxide PEO, polypropylene oxide PPO, polyethylene glycol PEG, or polyvinyl ether PVE; resins having an amide group or an amide bond such as polyacryl amide PAAM or polyvinyl pyrrolidone PVP; resins having as a dissociation group a carboxyl group such as polyacrylic acid salts, maleic acid resins, alginates or gelatins; polystyrene sulfonic acid salt; resins having an amino group, an imino group, a tertiary amino group or a quaternary ammonium group such as polyallylamine PAA, polyethylene imine PEI, epoxidated polyamide EPAM, polyvinyl pyridine or gelatins.

The hydrophobic binder may be any as long as it exhibits hydrophobicity, and examples of the hydrophobic binder include polymers derived from α,β-ethylenically unsaturated monomers such as polyvinyl chloride, chlorinated polyvinyl chloride, a copolymer of vinyl chloride and vinylidene chloride, a copolymer of vinyl chloride, and vinyl acetate, polyvinyl acetate, partially saponified polyvinyl acetate, polyvinyl acetal or preferably polyvinyl butyral in which a part of polyvinyl alcohol is acetalized with aldehyde, a copolymer of acrylonitrile and acryl amide, polyacrylates, polymethacrylates, polystyrene, polyethylene and a mixture thereof.

It is preferred that the back coat layer contains a matting agent, in order to easily mount the printing plate on a printing press and to prevent "out of color registration" due to "out of registration" of the printing plate during printing. As the matting agent, a porous or non-porous matting agent or an organic or inorganic matting agent can be used. Examples of the inorganic matting agent include silica, alumina, zirconia, titania, carbon black, graphite, TiO₂, BaSO₄, ZnS, MgCO₃, CaCO₃, ZnO, CaO, WS₂, MoS₂, MgO, SnO₂, Al₂O₃, α-Fe₂O₃, α-FeOOH, SiC, CeO₂, BN, SiN, MoC, BC, WC, titanium carbide, corundum, artificial diamond, garnet, garnet, quartz, silica rock, tripoli, diatomite, and dolomite. Examples of the organic matting agent include polyethylene fine particles, fluororesin particles, guanamine resin particles, acrylic resin particles, silicone resin particles, melamine resin particles, and the like.

As the inorganic material coated matting agents, there are, for example, particles in which organic particles such as particles of PMMA or polystyrene as core particles are coated with inorganic particles with a particle diameter smaller that that of the core particles. The particle diameter of the inorganic particles is preferably from 1/10 to 1/100 of that of the core particles. As the inorganic particles, particles of known metal oxides such silica, alumina, titania and zirconia can be used. Various coating methods can be used, but a dry process is preferred which core particles collide with particles for coating at high speed in air as in a hybridizer to push the particles for coating in the core particle surface and fix, whereby the core particles are coated with the particles for coating.

In the invention, any matting agent can be used without special limitations. Particularly when the planographic printing plate material is in the form of roll, the matting agent in the back coat layer is preferably organic resin particles in minimizing scratches on the image formation layer surface.

The average particle diameter of the matting agent is determined in terms of an average diameter of circles having the same area as projected images of the particles photographed by means of an electron microscope.

The average particle diameter of the matting agent is preferably from 1 to 12 µm, more preferably from 1.5 to 8 µm, and still more preferably from 2 to 7 µm. The above range of the average particle diameter is preferred in minimizing scratches on the image formation layer surface, or in providing good fixation of a planographic printing plate material to a plate cylinder. The matting agent content of the back coat layer is preferably from 0.2 to 30% by weight, and more preferably from 1 to 10% by weight.

A laser recording apparatus or a processless printing press has a sensor for controlling transportation of the printing plate material. In the invention, in order to carry out the controlling smoothly, the structural layer preferably contains dyes or pigment. The dyes or pigment are preferably infrared absorbing dyes or pigment as described above used as a light-to-heat conversion material. The structural layer can further contain a surfactant.

### EXAMPLES

The present invention will be detailed employing the following examples, but the invention is not limited thereto. Support

### (Preparation of support)

### (PET Resin)

Added to 100 parts by weight of dimethyl terephthalate, and 65 parts by weight of ethylene glycol, was 0.05 parts by weight of magnesium acetate anhydrate as an ester exchange catalyst, and an ester exchange reaction was conducted under commonly known practice. To the obtained product, added were 0.05 parts by weight of antimony trioxide and 0.03 parts by weight of trimethyl phosphate ester. Subsequently, subjected to a gradual temperature rise and pressure reduction, polymerization was conducted at 280 °C and at 0.5 mmHg, to obtain polyethylene terephthalate (PET) resin having an intrinsic viscosity of 0.70.

Employing the PET resin as obtained above, biaxially stretched PET film was prepared as described below.

### (Biaxially Stretched PET Film)

The PET resin was palletized and subjected to vacuum drying at 150 °C for 8 hours. After that, the resin was melt-extruded at 285 °C from a T die to form a layer, and the layer was electrostatically impressed on a 30 °C cooling drum while electrostatically impressed, and cooled to solidification, whereby unstretched film was obtained. This unstretched film was stretched at a factor of 3.3 in the longitudinal direction, employing a roll type longitudinal stretching machine. Subsequently, the resulting uniaxially stretched film, using a tenter type transverse stretching machine, was stretched at 90 °C by 50% of the total transverse stretch magnification in the first stretching zone, and then stretched at 100 °C in the second stretching zone so that the total transverse stretch magnification was 3.3. Further, the resulting film was preheated at 70 °C for two seconds, heat-set at 150 °C for five seconds in the first setting zone and at 220 °C for 15 seconds in the second setting zone, and relaxed at 160 °C by 5% in the transverse (width) direction. After passed through the tenter, the film was cooled to room temperature in 60 seconds, released from the clips, slit and wound around a core to obtain a 175 µm thick biaxially stretched PET film. The Tg of this biaxially stretched PET film was 79 °C, and the thickness distribution of the film was 2%.

The one surface of the biaxially stretched PET film prepared above was subjected to corona discharge treatment at 8 W/m²·minute. Subsequently, the following subbing layer coating solution a-1 was coated on the support and dried at 123 °C to form on a hydrophilic layer side an under layer (subbing layer) A-1 with a dry thickness of 0.8 µm. (Hereinafter, an under layer are also referred to as a subbing layer.) The other surface of the biaxially stretched PET film was subjected to corona discharge treatment at 8 W/m²·minute, and the subbing layer coating solution b-1 was coated at 23 °C on the resulting surface and dried at 123 °C to form a subbing layer B-1 with a dry thickness of 0.1 µm, which had anti-static property.

Subsequently, both of the subbing layers A-1 and B-1 were subjected to corona discharge treatment at 8 W/m²·minute. After that, the subbing layer coating solution a-2 was coated on the resulting subbing layer A-1 and dried at 123 °C to form a subbing layer A-2 with a dry thickness of 0.1 µm, and the subbing layer coating solution a-2 was coated on the resulting subbing layer B-1 and dried at 123 °C to form a subbing layer B-2 with a dry thickness of 0.2 µm. The resulting support was further subjected to heat treatment at 123 °C for 2 minutes. Thus, subbed support sample 1-1 was prepared.

### (Subbing layer coating solution a-1)

### <<Subbing layer coating solution a>>

| | |
|---|---|
| Styrene-butadiene latex with a solid content of 30% (Nipol LX 432A produced by Nippon Zeon Co., Ltd.) | 55 g |
| Anionic surfactant S-1 (2%) | 30 g |

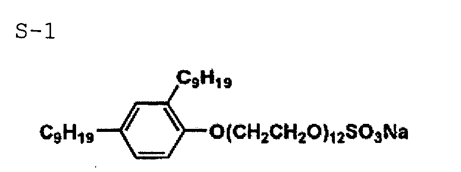

Water was added to make 1 kg.

### (Subbing layer coating solution b-1)

| | |
|---|---|
| Metal oxide F-1 (SnO₂ sol (8.3% by volume content) | 109.5 g |
| Styrene-butadiene latex with a solid content of 30% (Nipol LX 432A produced by Nippon Zeon Co., Ltd.) | 55 g |
| Anionic surfactant S-1 (2%) | 30 g |

Distilled water was added to make 1 kg.

### (Subbing layer coating solution a-2)

| | |
|---|---|
| Gelatin (GEL) | 2.5 g |
| Water | 20.0 g |
| Syloid manufactured by Fuji Davison Co. (grade 978, average particle size 2.5 µm) | 0.6 g |
| Carbon black dispersion (solid content: 32%) | 0.8 g |
| Condensation product of ethylene urea and formalin (Hardener A) described in Japanese Patent Publication No. 57-46771 | 0.5 g |
| Glyoxal (30% aqueous solution) | 0.5 g |
| Polylac 752A (styrene·butaidiene latex, solid content: 47.5%) manufactured by Mitusi Toatsu Kagaku Co., Ltd. | 5.0 g |
| Anionic surfactant S-1 (2%) | 0.6 ml |

Water was added to make 50.0 g.

Samples employing the plastic support and subbing layer as shown in Table 5 were prepared in the same manner as in Sample 1-1. In Samples 1-4 and 1-5, a polylactic acid film as described later was employed instead of biaxially stretched PET. In Samples 1-2, 1-3 and 1-5, the latex of coating solutions a-1 and b-1, which are the subbing layer A-1 coating solution and the subbing layer B-1 coating solution, respectively, was replaced with latex as shown in Table 5, and coating solution a-2, which is the coating solution of subbing layers A-2 and B-2, was replaced with subbing layer coating solution b-2 as shown in Table 5.

As the support of Sample 1-3, the same PET as in Sample 1-1 was employed.

### (Polylactic acid film)

A composition containing 100 parts by weight of poly-L-lactic acid (Tg=61,6 °C, Tm = 170 °C9 and 0.06 parts by weight of aggregate silica particles with an average particle size of about 1.8 µm as a lubricant for forming unevenness on a surface was extruded at a polymer temperature of 210 °C on a support employing an extruder with an opening of 30 mm equipped with a T die, cooled with a chilled roller of 20 °C to obtain an unstretched film. This unstretched film was preheated to 95 °C employing plural ceramic rollers, and stretched at a factor of 1.5 in the longitudinal direction at 28000%/minute, and further stretched at 97 °C at a factor of 12.7 in the longitudinal direction. Subsequently, the resulting uniaxially stretched film was stretched at 80 °C at a factor of 3.8 in the transverse direction in a tenter type stretching machine, heat set at 150 °C and relaxed at 135 °C by 3% in the transverse direction. Thus, a 175 µm thick biaxially stretched film in the invention was obtained.

### (Subbing Layer Coating Solution b-2)

| | |
|---|---|
| Modified water-soluble polyester L-3 solution (with a solid content of 18% by weight) | 150 g |
| RS-2117 produced by Kuraray Co., Ltd. (5%) (PVA) | 50 g |
| Anionic surfactant S-1 (2%) | 6 g |
| Spherical silica matting agent SEAHOSTAR KE-P50 (produced by Nippon Shokubai Co., Ltd.) 2% dispersion | 10 g |

Distilled water was added to make 1000 ml.

### (Preparation of Water-Soluble Polyester Solution)

A mixture consisting of 35.4 parts by weight of dimethyl terephthalate, 33.63 parts by weight of dimethyl isophthalate, 17.92 parts by weight of sodium salt of dimethyl 5-sulfoisophthalate, 62 parts by weight of ethylene glycol, 0.065 parts by weight of calcium acetate monohydrate, and 0.022 parts by weight of manganese acetate tetrahydrate was subjected to ester exchange reaction at 170 to 220 °C under a flow of nitrogen while distilling out methanol. Thereafter, 0.04 parts by weight of trimethyl phosphate, 0.04 parts by weight of antimony trioxide, and 6.8 parts by weight of 4-cyclohexanedicarboxylic acid were added. The resulting mixture underwent esterification at a reaction temperature of 220 to 235 °C while distilling out a nearly theoretical amount of water. Thereafter, the reaction system was heated over a period of one hour under reduced pressure, and subjected to polycondensation under a maximum pressure of 133 Pa for 1 hour, while heated to a final temperature of 280 °C. Thus, water-soluble polyester A-1 was prepared. The intrinsic viscosity of the polyester A-1 was 0.33.

Subsequently, 850 ml of pure water was placed in a 2-liter three-necked flask fitted with stirring blades, a refluxing cooling pipe, and a thermometer, and 150 g of the water-soluble polyester A-1 was gradually added while rotating the stirring blades. The resulting mixture was stirred at room temperature for 30 minutes, heated to 98 °C over a period of 1.5 hours, and maintained at that resulting temperature for 3 hours, whereby dissolution was performed. Thereafter, the mixture was cooled to room temperature over a period of one hour, and allowed to stand overnight, whereby a 15% by weight water-soluble polyester solution was prepared.

### (Preparation of Modified Polyester Lx-3 Solution)

One thousand nine hundred milliliters of the foregoing 15% by weight water-soluble polyester solution were placed in a 3-liter four-necked flask fitted with stirring blades, a reflux cooling pipe, a thermometer and a dripping funnel, and heated to 80 °C, while rotating the stirring blades. Into this added was 6.52 ml of a 24% aqueous ammonium peroxide solution, and a monomer mixture (consisting of 35.7 g of ethyl acrylate and 35.7 g of methyl methacrylate) was dropwise added over a period of 30 minutes, and the mixture was reacted for additional 3 hours. Thereafter, the reaction mixture was cooled to not more than 30 °C, and filtrated. Thus, a modified'polyester Lx-3 solution having a solid content of 18% by weight was obtained.

### (Preparation of Water-Soluble Polyester Solution)

A mixture consisting of 35.4 parts by weight of dimethyl terephthalate, 33.63 parts by weight of dimethyl isophthalate, 17.92 parts by weight of sodium salt of dimethyl 5-sulfoisophthalate, 62 parts by weight of ethylene glycol, 0.065 parts by weight of calcium acetate monohydrate, and 0.022 parts by weight of manganese acetate tetrahydrate was subjected to ester exchange reaction at 170 to 220 °C under a flow of nitrogen while distilling out methanol. Thereafter, 0.04 parts by weight of trimethyl phosphate, 0.04 parts by weight of antimony trioxide, and 6.8 parts by weight of 4-cyclohexanedicarboxylic acid were added. The resulting mixture underwent esterification at a reaction temperature of 220 to 235 °C while distilling out a nearly theoretical amount of water. Thereafter, the reaction system was heated over a period of one hour under reduced pressure, and subjected to polycondensation under a maximum pressure of 133 Pa for 1 hour, while heated to a final temperature of 280 °C. Thus, water-soluble polyester was prepared. The intrinsic viscosity of the polyester was 0.33, and Mw of the resulting polyester was 80,000 to 100,000.

Subsequently, 850 ml of pure water was placed in a 2-liter three-necked flask fitted with stirring blades, a refluxing cooling pipe, and a thermometer, and 150 g of the water-soluble polyester A-1 was gradually added while rotating the stirring blades. The resulting mixture was stirred at room temperature for 30 minutes, heated to 98 °C over a period of 1.5 hours, and maintained at that resulting temperature for 3 hours, whereby dissolution was performed. Thereafter, the mixture was cooled to room temperature over a period of one hour, and allowed to stand overnight, whereby a 15% by weight water-soluble polyester solution was prepared.

### (Preparation of Modified Water Soluble Polyester LX-3 Solution)

One thousand nine hundred milliliters of the foregoing 15% by weight water-soluble polyester A-1 solution were placed in a 3-liter four-necked flask fitted with stirring blades, a reflux cooling pipe, a thermometer and a dripping funnel, and heated to 80 °C, while rotating the stirring blades. Into this added was 6.52 ml of a 24% aqueous ammonium peroxide solution, and a monomer mixture (consisting of 28.5 g of glycidyl methacrylate, 21.4 g of ethyl acrylate and 21.4 g of methyl methacrylate) was dropwise added over a period of 30 minutes, and the mixture was reacted for additional 3 hours. Thereafter, the reaction mixture was cooled to not more than 30 °C, and filtrated. Thus, a modified water soluble polyester (containing a vinyl component-modified rate of 20% by weight) LX-3 solution having a solid content of 18% by weight was obtained.

### Common: Preparation of Back Coat Layer Coating Solution

Materials in the composition as shown in Table 1 were sufficiently mixed while stirring, employing a homogenizer, and filtered to obtain a back coat layer coating solution.

**Table 1**

| Materials | Addition Amount |
|---|---|
| Colloidal silica: Snowtex XS (solid content of 20% by weight, produced by Nissan Kagaku Co., Ltd.) | 33.60 g |
| Acryl emulsion: DK-05 (solid content of 48% by weight, produced by GifuCerac Co., Ltd.) | 14.00 g |
| Matting agent (PMMA with an average particle size of 5.5 µm) | 0.56 g |
| Pure water | 51.84 g |
| Solid content (% by weight) | 14% |

### (Coating of Back Coat Layer Coating Solution)

The back coat layer coating solution was coated, through a wire bar #6, on the subbing layer surface B of each of the subbed supports 1-1, 1-3, 1-4 and 1-5, and allowed to pass through a 100 °C drying zone with a length 15 m at a transportation speed of 15 m/minute to form a back coat layer with a coating amount of 2.0 g/m².

### On-press Development Type: Preparation of Lower Hydrophilic Layer Coating Solution

Materials as shown in Table 2 were sufficiently mixed while stirring, employing a homogenizer, and filtered to obtain a lower hydrophilic layer coating solution.

**Table 2**

| Materials | Addition Amount |
|---|---|
| Colloidal silica: Snowtex XS (solid content of 20% by weight, produced by Nissan Kagaku Co., Ltd.) | 51.94 g |
| Porous metal oxide particles Silton JC 40 (porous aluminosilicate particles having an average particle size of 4 µm, produced by Mizusawa Kagaku Co., Ltd.) | 2.22 g |
| Surface-coated melamine resin particles: STM-65005 (produced by Nissan Kagaku Co., Ltd.) with an average particle size of 6.5 µm | 3.00 g |
| Layer structural clay mineral montmorillonite: Water-swelled gel prepared by vigorously stirring Mineral Colloid MO (produced by Southern Clay Products Co., Ltd.) with an average particle size of 0.1 µm) in water in a homogenizer to give a solid content of 5% by weight | 4.44 g |
| Cu-Fe-Mn type metal oxide black pigment: 40% by weight aqueous dispersion of TM-3550 black powder (having a particle size of 0.1 µm produced by Dainichi Seika Kogyo Co., Ltd.) (including 0.2% by weight of dispersant) | 10.00 g |
| 4% by weight sodium carboxymethyl cellulose Aqueous solution (Reagent produced by Kanto Kagaku Co., Ltd.) | 2.80 g |
| 10% by weight sodium phosphate·dodecahydrate aqueous solution (Reagent produced by Kanto Kagaku Co., Ltd.) | 0.56 g |
| Pure Water | 25.04 g |
| Solid content (% by weight) | 20% |

### On-press Development Type: Preparation of Upper Hydrophilic Layer Coating Solution

**Table 3**

| Materials | Addition Amount |
|---|---|
| Colloidal silica: Snowtex S (solid content of 30% by weight, produced by Nissan Kagaku Co., Ltd.) | 5.2 g |
| Necklace shaped colloidal silica Snowtex PSM (solid content of 20% by weight, produced by Nissan Kagaku Co., Ltd.) | 11.7 g |
| Colloidal silica (Alkali type): MP-4540 (having an average particle size of 0.4 µm, solid content of 30% by weight, produced by Nissan Kagaku Co., Ltd.) | 4.5 g |
| Porous metal oxide particles Silton JC 20 (porous aluminosilicate particles having an average particle size of 2 µm, produced by Mizusawa Kagaku Co., Ltd.) | 1.2 g |
| Porous metal oxide particles Silton AMT 08 (porous aluminosilicate particles having an average particle size of 0.6 µm, produced by Mizusawa Kagaku Co., Ltd.) | 3.6 g |
| Layer structural clay mineral montmorillonite: Water-swelled gel prepared by vigorously stirring Mineral Colloid MO (produced by Southern Clay Products Co., Ltd.) with an average particle size of 0.1 µm) in water in a homogenizer to give a solid content of 5% by weight | 4.8 g |
| Cu-Fe-Mn type metal oxide black pigment: 40% by weight aqueous dispersion of TM-3550 black powder (having a particle size of 0.1 µm produced by Dainichi Seika Kogyo Co., Ltd.) (including 0.2% by weight of dispersant) | 2.7 g |
| 4% by weight sodium carboxymethyl cellulose aqueous solution (Reagent produced by Kanto Kagaku Co., Ltd.) | 3.0 g |
| 10% by weight sodium phosphate·dodecahydrate aqueous solution (Reagent produced by Kanto Kagaku Co., Ltd.) | 0.6 g |
| Pure Water | 62.7 g |
| Solid content (% by weight) | 12% |

Materials as shown in Table 3 above were sufficiently mixed while stirring, employing a homogenizer, and filtered to obtain an upper hydrophilic layer coating solution.

The lower hydrophilic layer coating solution was coated, through a wire bar #5, on the rear surface (subbing layer surface A side) of each of the resulting supports obtained above, and allowed to pass through a 100 °C drying zone with a length 15 m at a transportation speed of 15 m/minute to form a lower hydrophilic layer. Successively, the upper hydrophilic layer coating solution was coated on the resulting lower hydrophilic layer employing a wire bar #3, and allowed to pass through a 100 °C drying zone with a length 30 m at a transportation speed of 15 m/minute to form an upper hydrophilic layer. The coating amount of the lower layer and that of the upper layer were 3.0 g/m² and 0.55 g/m², respectively. The resulting support samples were further subjected to aging treatment at 60 °C for one day.

Evaluation to coatability of the lower hydrophilic layer is described later.

### On-press Development Type: Preparation of Image Formation Layer Coating Solution and Planographic Printing Plate Materials

Materials as shown in Table 4 below were sufficiently mixed while stirring, employing a homogenizer, and filtered to obtain an upper hydrophilic layer image formation layer coating solution.

**Table 4**

| Materials | Addition Amount |
|---|---|
| Carnauba wax emulsion A118 (with an average particle diameter of 0.3 µm, a softening point of 65 °C, a melting point of 80 °C, a melt viscosity at 140 °C of 8 cps and a solid content of 40% by weight, produced by Gifu Shellac Co., Ltd.) | 16.0 g |
| Microcrystalline wax emulsion A206 (with an average particle diameter of 0.5 µm, and a solid content of 40% by weight, produced by Gifu Shellac Co., Ltd.) | 5.9 g |
| Sodium polyacrylate DL-522 (with an average molecular weight of 170,000 and a solid content of 30% by weight, produced by Nippon Shokubai Co., Ltd.) | 2.4 g |
| Pure water | 75.7 g |
| Solid content (% by weight) | 9.5% |

The image formation layer coating solution was coated, through a wire bar #5, on the upper hydrophilic layer obtained above, and allowed to pass through a 70 °C drying zone with a length 30 m at a transportation speed of 15 m/minute to form an image formation layer with a coating amount of 0.5 g/m². The resulting material was subjected to aging treatment at 50 °C for two days to obtain a planographic printing plate material.

The planographic printing plate material was cut into a 600 mm width, and wound around a paper core with an outside diameter of 76 mm by a length of 30 m. Thus, planographic printing plate material in roll was obtained.

### (Silver Salt type)

The above common back coat layer coating solution was coated on the support 1-2, then a green-sensitized silver chloride emulsion with high contrast was coated in an amount of 1.5 g/m² in terms of silver nitrate, dried and heated at 50 °C for 2 days. On the resulting emulsion layer was coated a solution which was prepared by adding sodium polyacrylate (having an average molecular weight of 260,000) in an amount of 0.04 g/m² to a nucleus coating solution (containing No. 3 acrylamide-imidazole copolymer as a polymer and hydroquinone as a developing agent in an amount of 0.8 g/m²) described in Example 2 of Japanese Patent O.P.I. Publication Nos. 58-21602.

The resulting planographic printing plate material was imagewise exposed and subjected to development, employing an automatic plate making processor CP-414S manufactured by Mitsubishi Seishi Co., Ltd. Development was carried out at 30 °c for 15 seconds, employing the following diffusion transfer developer. Stabilization was carried out at 25 °c for 10 seconds, employing the following stabilizer diffusion transfer developer, followed by drying.

### <Diffusion Transfer Developer>

| | |
|---|---|
| Water | 700 g |
| Sodium hydroxide | 18 g |
| Potassium hydroxide | 7 g |
| Anhydrous sodium sulfite | 50 g |
| 2-Mercaptobenzoic acid | 1 g |
| Uracil | 10 g |
| 2-Methylaminoethanol | 30 g |
| 5-Phenyl-2-mercapto-1,3,4-oxadiazole | 0.1 g |
| Potassium bromide | 1 g |

Water was added to make 1000 ml.

### <Stabilizer>

| | |
|---|---|
| Water | 600 g |
| Citric acid | 10 g |
| Sodium citrate | 35 g |
| Colloidal silica (20%) | 5 g |
| Ethylene glycol | 5 g |

Water was added to make 1000 ml.

### (Printing)

Employing a printing press DAIYA 1F-1 produced by Mitsubishi Jukogyo Co., Ltd., printing was carried out in which coated paper sheet, dampening water Astromark 3 (produced by Nikken Kagaku Kenkyusyo Co., Ltd., 2% by weight), and the following two kinds of printing inks were employed, and evaluation was made.
Ink 1: Toyo King Hyeco M Magenta, produced by Toyo Ink Manufacturing Co.).
Ink 2: TM Hyeco SOY1, produced by Toyo Ink Manufacturing Co.)

### Evaluation of initial printability (paper waste)

The number of paper sheets printed from when printing started till when an image with a good S/N ratio (where no stain was observed at non-image portions, i.e., the image formation layer at the non-image portions was completely removed on a press, and the image portions had a sufficient density, and particularly development failure, resulting from scratches of the image formation layer caused by the matting agent of the backing layer, was not observed.) was obtained was counted as the number of paper wastes, and evaluated as a measure of initial printability. The less the number of paper wastes is, the better the initial printability. The number of paper wastes of not less than 40 is practically problematic.

### Evaluation of printing durability

The number of paper sheets printed from when printing started till when elimination of dots at the 3% dot image portion or density reduction at solid image potions was observed was counted and evaluated as printing durability. Evaluation of biodegradation properties

In a 100 liter compost were placed 5 kg of raw garbage, and a 10 cm square specimen in which the planographic printing plate material obtained above obtained was cut was superposed on the raw garbage. Further, raw garbage was superposed on the specimen at a thickness of 5 cm, and allowed to stand for one month. After that, the specimen was observed and evaluated according to the following criteria. This evaluation test was carried out at summer season.
A: The physical properties were deteriorated, and the original shape was not maintained.
B: Deformation and blanching were observed but the shape was maintained.
C: Neither deformation nor blanching was observed, maintaining the original shape.

### Evaluation of recycling property of plastic film

A 10 cm square specimen, in which the planographic printing plate material obtained above obtained was cut, was immersed for 20 minutes. After that, the specimen was observed and evaluated according to the following criteria.
A: The coating was completely separated from the film.
B: Only a part of the coating was separated from the support film.
C: Not less than 80% of the coating remained without being separated from the support film.

**Table 5**

| Sam ple | Remarks | Plastic Support | Subbing Layer | Kind of Layer | Environmental properties | | Developabi lity (Number) | Printing Durability (Number) |
|---|---|---|---|---|---|---|---|---|
| | | | Lower/ Upper | Type | Bio-degradation | Recycling | | |
| 1-1 | Comp. | PET | ST-BT/ GEL | *2) | C | C | 40 | 12000 |
| 1-2 | Comp. | PET | *1) | *3) | C | A | x | 26000 |
| 1-3 | Inv. | PET | *1) | *2) | C | A | 10 | 40000 |
| 1-4 | Inv. | Poly-lactic acid | None | *2) | A | A | 13 | 24000 |
| 1-5 | Inv. | Poly-lactic acid | *1) | *2) | A | A | 11 | 47000 |

| | | | | | | | | |
|---|---|---|---|---|---|---|---|---|
| Comp.: Comparative, Inv.: Inventive *1): Acryl/(Modified polyester + PVA) *2): On-press development type *3): Silver salt type | | | | | | | | |

### Acryl: Styrene-butyl acrylate-glycidyl methacrylate (40/40/20) three-component copolymer (Tg=20 °C) latex and styrene-butyl acrylate-hydroxymethacrylate (27/45/20) copolymer (Tg=45 °C) latex (4:1) St-BT: Styrene-butadiene latex (Nipol LX432A produced by Nippon Zeon Co., Ltd., Tg = -55°C)

As is apparent from Table 5, the planographic printing plate materials of the present invention provide printing properties that excel in on-press developability and printing durability.

## Claims

1. A planographic printing plate material comprising a plastic support and provided thereon, at least an image formation layer, wherein the plastic support is comprised of a resin whose main component is polylactic acid.

2. The planographic printing plate material of claim 1, wherein a layer capable of being separated from the plastic support with an alkali solution having a pH of from 9 to 12 is provided on the plastic support.

3. The planographic printing plate material of claim 1 or 2, wherein the image formation layer is capable of being subjected to on-press development.

4. The planographic printing plate material of any one of claims 1 through 3, wherein a subbing layer containing at least one compound selected from the group consisting of a vinyl polymer, polyester and an acryl-modified polyester is provided on the plastic support.

5. The planographic printing plate material of any one of claims 1 through 4, wherein the planographic printing plate material is in the form of roll.

6. A printing method comprising the steps of:
forming an image on the planographic printing plate material of any one of claims 1 through 5, employing a thermal head or a thermal laser;
developing the resulting planographic printing plate material on a planographic printing press by supplying dampening water or both of dampening water and printing ink thereto; and
carrying out printing.

7. A method of collecting the plastic support from the planographic printing plate material of any one of claims 1 through 5, the method comprising processing the planographic printing plate material with an alkali solution having a pH of from 9 to 12.

8. A planographic printing plate material comprising a plastic support and provided thereon, at least an image formation layer, wherein a layer capable of being separated from the plastic support with an alkali solution having a pH of from 9 to 12 is provided on the plastic support.

9. The planographic printing plate material of claim 8, wherein the image formation layer is capable of being subjected to on-press development.

10. The planographic printing plate material of claim 8 or 9, wherein a subbing layer containing at least one compound selected from the group consisting of a vinyl polymer, polyester and an acryl-modified polyester is provided on the plastic support.

11. The planographic printing plate material of any one of claims 8 through 10, wherein the planographic printing plate material is in the form of roll.

12. A printing method comprising the steps of:
forming an image on the planographic printing plate material of any one of claims 8 through 11, employing a thermal head or a thermal laser;
developing the resulting planographic printing plate material on a planographic printing press by supplying dampening water or both of dampening water and printing ink thereto; and
carrying out printing.

13. A method of collecting the plastic support from the planographic printing plate material of any one of claims 8 through 11, the method comprising processing the planographic printing plate material with an alkali solution having a pH of from 9 to 12.
